# EUROPÄISCHE PATENTSCHRIFT

(11) **EP 3 368 822 B1**
(45) Veröffentlichungstag und Bekanntmachung des Hinweises auf die Patenterteilung: **28.08.2019**
(21) Anmeldenummer: 16790550.4
(22) Anmeldetag: 28.10.2016
(51) Int. Cl.: H01L 25/075, H01L 25/16, F21V 21/08

(54) **VORRICHTUNG ZUR BILDDARSTELLUNG**
IMAGE PRESENTATION DEVICE
DISPOSITIF DE REPRESENTATION D'IMAGE

(30) Priorität: 28.10.2015 EP 15191954
(43) Veröffentlichungstag der Anmeldung: 05.09.2018
(73) Patentinhaber: TFFI GmbH & Co KG, 1010 Wien (AT)
(72) Erfinder: MAYER, Sebastian, 7100 Neusiedl am See (AT)
(74) Vertreter: Sonn & Partner Patentanwälte
(86) Internationale Anmeldenummer: PCT/EP2016/076011
(87) Internationale Veröffentlichungsnummer: WO 2017/072269

(56) Entgegenhaltungen:
- EP-A1- 1 600 688
- EP-A1- 2 869 670
- WO-A2-2005/028774
- DE-A1-102006 031 345
- US-A1- 2009 297 156

## Beschreibung

Die Erfindung betrifft eine Vorrichtung zur Bilddarstellung mit einem Trägerkörper, auf welchem mit jeweils einer Ansteuereinheit verbundene, einzeln ansteuerbare Leuchtkörper angeordnet sind.

Vorrichtungen der oben genannten Art sind aus dem Stand der Technik bekannt. Beispielsweise können in der Art einer Lichterkette angeordnete Leuchtdioden (LEDs) jeweils mit einem programmierbaren Mikrocontroller verbunden sein, um separate Steuerleitungen zu jeder LED zu vermeiden und insgesamt außer zwei Stromversorgungsleitungen nur eine Busleitung bereitstellen zu müssen. Auf diese Weise können LED-Streifen mit einzeln steuerbaren LEDs zur Darstellung verschiedener Muster gebildet werden. Zudem sind LED-Paneele für die Darstellung von Schriften sowie Videoinhalten bekannt.

Aus der EP 1 600 688 A1 geht eine Beleuchtungsfläche zur Bilddarstellung bestehend aus einer Trägerfläche hervor, auf welcher einzeln ansteuerbare LEDs befestigt oder darin eingebettet sind. Die Trägerfläche ist zu beiden Seiten lichtdurchlässig ausgebildet und die LEDs sind derart in einem Abstand zueinander angeordnet, dass erkennbar Umgebungslicht durch die Beleuchtungsfläche hindurch tritt. Die LEDs können eine Ansteuereinheit, beispielsweise einen integrierten Schaltkreis, aufweisen und über matrixartig angeordnete Leitungen oder drahtlos, beispielsweise über induktive oder kapazitive Kopplung, ein- und ausgeschaltet oder gedimmt werden. Für die Steuerung der einzelnen LEDs können diesen Adressen zugeordnet sein, welche digital übermittelt werden.

Die DE 10 2006 031345 A1 offenbart ein andersartiges formflexibles Beleuchtungssystem mit zumindest einer Leuchtdiode, die auf einem flexiblen Trägermaterial angeordnet ist. Diese Anordnung ist in einer Hohlprofilschiene mit im Wesentlichen rechteckigen Querschnitt aufgenommen, in der die Leuchtdioden benachbart angeordnet sind und eine gemeinsame Leuchtfläche ausbilden. Die Hohlprofilschiene ist stirnseitig von einem Endstück und/oder einem elektrischen Stecksystem verschlossen. Die Hohlprofilschiene ist zur Befestigung des Beleuchtungssystems formschlüssig in ein Montageprofil einschiebbar.

Aus der US 2009/297156 A1 ist ein andersartiges Beleuchtungs- und Lichtkommunikationssystem bekannt, welches aus einer Mehrzahl von Beleuchtungseinheiten und einer optischen Kommunikationseinheit, die Daten über die Luft zu den Beleuchtungseinheiten überträgt. Die Beleuchtungseinheiten empfangen Licht von der optischen Kommunikationseinheit aber auch von anderen Beleuchtungseinheiten. Damit werden gleichzeitig Daten erfasst, wobei das emittierte Licht der Beleuchtungseinheiten gemäß dieser Daten moduliert wird.

Die EP 2 869 670 A1 zeigt eine andersartige Leuchte bzw. Leuchtanordnung, die mehrere Leuchtmodule bzw. Leuchtsegmente enthält, deren Position innerhalb der Leuchte durch die Ermittlung der Temperatur des jeweiligen Leuchtmoduls mit Hilfe eines Temperatursensors bestimmt wird. Dem jeweiligen Leuchtmodul wird dann in Abhängigkeit dieser Position eine Adresse zugewiesen.

Nachteilig ist hierbei die unflexible Positionierung der LEDs, da diese zumindest in Abständen zueinander angeordnet werden müssen, die eine deutlich erkennbare Lichtdurchlässigkeit der Beleuchtungsfläche gewährleisten. Zudem ist die offenbarte Beleuchtungsfläche aufwändig aufgebaut.

Die Erfindung hat daher zum Ziel, eine Vorrichtung zur Bilddarstellung der eingangs genannten Art zu schaffen, welche die aus dem Stand der Technik bekannten Nachteile vermeidet oder zumindest verringert. Die Vorrichtung soll eine möglichst flexible Positionierung der Leuchtkörper auf einem möglichst einheitlich, einfach und günstig herstellbaren Trägerkörper ermöglichen. Zudem soll die Ausbildung der Vorrichtung auch unter starker mechanischer Belastung einen zuverlässigen Betrieb gewährleisten. Insbesondere soll die Vorrichtung für eine Farb-, Zeichen- und/oder Bilddarstellung konstanter oder sich auch rasch veränderbarer Informationen für verschiedene Anwendungsbereiche ausgebildet und die Formgebung im Anschluss an den Herstellungsvorgang durch einen Benutzer einfach zu ändern sein.

Diese Aufgabe wird durch eine Vorrichtung mit den Merkmalen von Anspruch 1 gelöst. Bevorzugte Ausführungen sind in den abhängigen Ansprüchen angegeben.

Erfindungsgemäß weist der Trägerkörper eine den Leuchtkörpern zugewandte erste elektrisch leitfähige Schicht, eine von den Leuchtkörpern abgewandte zweite elektrisch leitfähige Schicht und eine zwischen der ersten und zweiten elektrisch leitfähigen Schicht angeordnete lichtleitende Schicht zur Leitung von Lichtsignalen auf, wobei die Ansteuereinheiten über lichterfassende bzw. die Lichtsignale aufnehmende Anschlüsse mit der lichtleitenden Schicht verbunden sind, wobei erste elektrische Anschlüsse zur Verbindung der Ansteuereinheiten mit der ersten elektrisch leitfähigen Schicht und zweite elektrische Anschlüsse zur Verbindung der Ansteuereinheiten mit der zweiten elektrisch leitfähigen Schicht vorgesehen sind, wobei die Ansteuereinheiten zur Ansteuerung der Leuchtkörper in Abhängigkeit von in die lichtleitende Schicht eingespeisten Lichtsignalen ausgebildet sind.

Der Trägerkörper weist somit zumindest drei vorzugsweise flächig miteinander verbundene Schichten auf, von welchen die erste und zweite elektrisch leitfähige Schicht der Stromversorgung, vorzugsweise der Gleichstromversorgung, der Ansteuereinheiten und der jeweils damit verbundenen Leuchtkörper dient, während die lichtleitende Schicht sowohl der elektrischen Isolation der ersten von der zweiten elektrisch leitfähigen Schicht als auch der Übertragung von Lichtsignalen an die Ansteuereinheiten dient. Die Lichtsignale enthalten Informationen, insbesondere Steuer- und Adressinformationen für den Betrieb der Leuchtkörper. Diese Informationen werden von allen mit der lichtleitenden Schicht verbundenen Ansteuereinheiten erfasst, wobei die Ansteuereinheiten ausgebildet sind, die Steuer- und Adressinformationen zu verarbeiten. Die Adressinformationen, im Folgenden auch Adressen genannt, sind eindeutig, sodass jede Adresse einem einzigen Leuchtkörper oder einer definierte Gruppe von Leuchtkörpern zugeordnet ist. Zudem sind die Steuerinformationen den Adressen zugeordnet, sodass die Ansteuereinheiten zur Steuerung des jeweils damit verbundenen Leuchtkörpers nur jene Steuerinformationen in elektrische Signale umsetzen, welche der Adresse des Leuchtkörpers zugeordnet sind. Die Steuerinformationen können beinhalten, ob und für welche optische Darstellung ein Leuchtkörper aktiviert oder deaktiviert werden soll. Somit werden die Steuer- und Adressinformationen für alle Leuchtkörper über eine einzige lichtleitende Schicht übertragen und von den Ansteuereinheiten ausgewertet.

Die Ansteuereinheiten können Teil der Leuchtkörper oder mit diesen verbunden sein. Zudem sind die Ansteuereinheiten über lichterfassende Anschlüsse mit der lichtleitenden Schicht, über erste elektrische Anschlüsse mit der ersten elektrisch leitfähigen Schicht und über zweite elektrische Anschlüsse mit der zweiten elektrisch leitfähigen Schicht verbunden. Die lichterfassenden Anschlüsse und die ersten und zweiten elektrischen Anschlüsse können im Trägerkörper vorgesehen sein, wobei dann die Ansteuereinheiten für die Herstellung einer optisch und elektrisch leitfähigen Verbindung durch Aufsetzen auf die als Kontakte dienenden Anschlüsse ausgebildet sind. Bevorzugt weisen jedoch die Ansteuereinheiten jeweils einen lichterfassenden Anschluss und einen ersten und einen zweiten elektrischen Anschluss auf. Zur Herstellung der Kontakte mit der lichtleitenden Schicht und den elektrisch leitfähigen Schichten können die drei Anschlüsse in vorab im Trägerkörper vorgesehene Kontaktbohrungen eingesetzt werden. Bevorzugt sind die drei Anschlüsse jedoch in ihrer Formgebung und mechanischen Stabilität derart ausgebildet, dass sie ohne vorangehende Herstellung der Kontaktbohrungen in den Trägerkörper eingestochen werden können.

Um die Lichtsignale auswerten zu können, ist in der Ansteuereinheit, beispielsweise im lichterfassenden Anschluss der Ansteuereinheit, ein Lichtempfänger vorgesehen, welcher die Lichtsignale in elektrische Signale wandelt. Für eine geringe Baugröße des lichterfassenden Anschlusses ist es jedoch günstig, den Lichtempfänger in einem Abschnitt der Ansteuereinheit außerhalb des lichterfassenden Anschlusses anzuordnen, wobei dann der lichterfassende Anschluss als Lichtleiter ausgebildet ist, welcher die Lichtsignale von der lichtleitenden Schicht zum Lichtempfänger weiterleitet.

Eine besonders zweckmäßige Gestaltung des Trägerkörpers sieht beispielsweise vor, dass die obere und untere elektrisch leitfähige Schicht im Wesentlichen über ihre gesamte Erstreckung elektrisch leitfähig und die lichtleitende Schicht im Wesentlichen über ihre gesamte Erstreckung lichtleitend ausgebildet ist. Eine derartige Ausführung des Trägerkörpers ermöglicht im Gegensatz zu Trägerkörpern mit einzelnen Leiterbahnen eine im Wesentlichen beliebige Positionierung der Leuchtkörper am Trägerkörper, welcher somit für verschiedene Anwendungsfälle einheitlich, einfach und kostengünstig hergestellt werden kann. Der Trägerkörper kann in beliebigen, im Wesentlichen durch das Herstellungsverfahren beschränkten Größen, beispielsweise von einigen cm² bis hin zu einigen m², hergestellt werden.

Die auch als Isolationsschicht wirkende lichtleitende Schicht zur Übertragung der Steuer- und Adressinformationen für die Leuchtkörper bietet gegenüber einer Übertragung der Steuer- und Adressinformationen über die ersten und zweiten elektrisch leitfähigen Schichten oder über ein aus dem Stand der Technik bekanntes dichtes Netz elektrischer Leiterbahnen den wesentlichen Vorteil, dass die Steuer- und Adressinformationen auch bei sehr dünner Ausbildung der Isolationsschicht mit hohen Datenraten übertragen werden können. Da an den ersten und zweiten elektrisch leitfähigen Schichten nur Gleichspannung oder zumindest eine niederfrequente Spannung anliegt, hat die kapazitive Wirkung zwischen den einander nahen ersten und zweiten elektrisch leitfähigen Schichten keinen Einfluss auf eine hohe Datenrate der Steuer- und Adressinformationen. Die erfindungsgemäße Konstruktion der Vorrichtung ermöglicht somit insbesondere die Realisierung von Bildschirmen mit vielen anzusteuernden Leuchtkörpern und/oder einer hohen Bildwiederholrate, d.h. einer hohen Anzahl von mit der Vorrichtung darzustellenden Bildern pro Sekunde. Eine derart ausgebildete Vorrichtung erlaubt zudem eine nachträgliche Reduktion der Größe des Trägerkörpers, da die für die Stromversorgung und die Übertragung von Lichtsignalen vorgesehenen Schichten flächig miteinander verbunden sind und ein Abtrennen eines Teilabschnitts die Funktion der hierdurch größenreduzierten Vorrichtung nicht beeinträchtigt. Günstiger Weise ist der Trägerkörper aus mit einfachen Werkzeugen trennbaren Materialien aufgebaut. Die erfindungsgemäße Vorrichtung zur Bilddarstellung kann somit nach dem Herstellungsvorgang vom Anwender auf die gewünschte Größe und Form zugeschnitten werden und bietet hierdurch einen wesentlichen Vorteil gegenüber bekannten Vorrichtungen bzw. Bildschirmen, welche mit unveränderbaren Abmessungen und Formen hergestellt werden. So erfordert eine spezielle Formgebung einer Bildschirmfläche gemäß dem Stand der Technik eine im Allgemeinen sehr kostspielige Änderung des Herstellungsvorgangs. Im Vergleich dazu können erfindungsgemäße Vorrichtungen sowohl kostengünstig gegebenenfalls mit unterschiedlichen Abmessungen hergestellt als auch abhängig von ihrem Anwendungsbereich in ihrer Formgebung nachträglich geändert werden.

Gemäß einer bevorzugten Ausführungsform der Erfindung ist vorgesehen, dass die ersten und/oder zweiten elektrischen Anschlüsse und/oder die lichterfassenden Anschlüsse einen in Richtung weg von den Leuchtkörpern verjüngend ausgebildeten Abschnitt aufweisen. Die elektrischen und die lichterfassenden Anschlüsse können mittels dieser Abschnitte, welche sich bis zu den von den Leuchtkörpern abgewandten Enden der Anschlüsse erstrecken, einfach in den Trägerkörper, insbesondere in und durch die elektrisch leitfähigen Schichten und die lichtleitende Schicht, eingestochen werden. Die Anschlüsse können beispielsweise nadelförmig, kegelförmig oder pyramidenförmig ausgebildet sein. Es können jedoch ebenso nur einer oder zwei der Anschlüsse einen verjüngend ausgebildeten Abschnitt zumindest am von den Leuchtkörpern abgewandten Ende aufweisen. Beispielsweise kann der erste elektrische Anschluss als stumpfer Stift oder als flaches Kontaktelement auf die erste elektrisch leitfähige Schicht aufgesetzt werden. Wenn zumindest der lichterfassende Anschluss und der zweite elektrische Anschluss in den Trägerkörper eingestochen sind, kann im Falle geringer mechanischer Belastungen der Vorrichtung auf zusätzliche Befestigungsmittel für die Leuchtkörper am Trägerkörper verzichtet werden. Fallweise kann aber eine zusätzliche Fixierung der Leuchtkörper am Trägerkörper mittels einer Klebeverbindung zweckmäßig sein.

Für eine kostengünstige Herstellung der Vorrichtung zur Bilddarstellung in zahlreichen Anwendungsbereichen ist es günstig, wenn die Leuchtkörper Licht emittierende Dioden (LEDs), vorzugsweise für die Emission unterschiedlicher Lichtfarben steuerbare RGB LEDs oder elektrisch verformbare Materialien, insbesondere Piezokristalle, sind. Während LEDs günstige aktive Leuchtmittel sind, die gemeinsam eine Darstellung bewegter oder statischer, ein- oder mehrfarbiger Bilder ermöglichen, können derartige Bilder auch mit den elektrisch verformbaren Materialien, wie Piezokristallen, durch deren Verformung und eine daraus resultierende unterschiedliche Lichtreflexion erzeugt werden. Besondere Effekte der Bilddarstellung lassen sich hierbei erzielen, wenn die elektrisch verformbaren Materialien selbst mit ausgewählten Lichtmustern bestrahlt werden. Selbstverständlich ist auch eine Anordnung von LEDs und elektrisch verformbaren Materialien am selben Trägerkörper denkbar.

Wenn der Trägerkörper biegsam ist, kann die Vorrichtung zur Bilddarstellung an unebenen, insbesondere gekrümmten Flächen anliegend befestigt werden. Beispielsweise kann der Trägerkörper flächig, vorzugsweise im Wesentlichen vollflächig, an unebenen Werbeflächen, wie Säulen, befestigt werden, um die Vorrichtung hierauf als Plakatwand oder als gekrümmten Bildschirm zu verwenden. Ein biegsam ausgeführter Trägerkörper kann zudem platzsparend, beispielsweise zusammengerollt, aufbewahrt werden, oder als aufrollbare Bildfläche in der Art eines dem Sichtschutz dienenden Rollos mit fixem oder veränderbarem Bildinhalt Verwendung finden. Auch eine Verwendung als an unebenen Flächen montierte Beleuchtungsfläche ist möglich. Das maximale erzielbare Ausmaß der Biegung bzw. der kleinstmögliche Biegeradius hängt unter anderem von den verwendeten Materialien und von der Dicke und dem konkreten Aufbau der Vorrichtung ab. Beispielsweise kann der Biegeradius zumindest 20cm bei einer Dicke des Trägerkörpers von zumindest 3mm betragen. Die erste und zweite elektrisch leitfähige Schicht sowie die lichtleitende Schicht sind aus einem flexiblen bzw. biegsamen Material ausgebildet. Eventuell sind auch die ersten und die zweiten elektrischen Anschlüsse und die lichterfassenden Anschlüsse aus einem flexiblen bzw. biegsamen Material ausgebildet, um einer Krümmung des Trägerkörpers möglichst nicht entgegenzuwirken. Günstiger Weise ist die Dicke des Trägerkörpers sehr viel kleiner als seine Längen- und Breitenabmessungen, sodass der Trägerkörper als Folie ausgebildet sein kann.

Wenn die erste elektrisch leitfähige Schicht mit einer die Leuchtkörper zumindest teilweise einbettenden Deckschicht verbunden ist, kann die Vorrichtung wirksam vor schädigenden mechanischen Einflüssen oder Umwelteinflüssen geschützt werden. Zudem können die Leuchtkörper, wenn diese zumindest teilweise in die Deckschicht eingebettet sind, hierdurch in ihrer Position auf dem Trägerkörper fixiert werden. Um Beschädigungen der Leuchtkörper möglichst zu vermeiden ist es jedoch zweckmäßig, diese vollständig in die Deckschicht einzubetten und die Deckschicht aus im Wesentlichen kratzfestem und/oder druckfestem, lichtdurchlässigem Kunststoffmaterial herzustellen. Eine solcher Art geschützte Vorrichtung kann auch in feuchter Umgebung oder als Fußbodenelement verwendet werden. Günstiger Weise ist die Deckschicht auch elastisch ausgebildet, um eine Krümmung der Vorrichtung nicht zu behindern.

Um die Vorrichtung auch auf elektrisch leitenden bzw. Strom führenden Flächen montieren und die Vorrichtung auch im Betrieb gefahrlos berühren zu können, ist es vorteilhaft, wenn die zweite elektrisch leitfähige Schicht auf der von den Leuchtkörpern abgewandten Seite mit einer elektrisch isolierenden Schicht verbunden ist. Die elektrisch isolierende Schicht ist bevorzugt aus einem dünnen, flexiblen Kunststoffmaterial hergestellt.

Für eine rasche Befestigung der Vorrichtung an einer Aufnahmefläche, ohne gesonderte Befestigungsmittel bereitstellen zu müssen, ist es günstig, wenn der Trägerkörper auf der von den Leuchtkörpern abgewandten Seite Befestigungsmittel, insbesondere eine Selbstklebeschicht, aufweist. Um die Vorrichtung nach ihrer Demontage unzerstört wiederverwenden zu können, sind die Befestigungsmittel bevorzugt für eine lösbare Befestigung der Vorrichtung ausgebildet. Als Befestigungsmittel kommen beispielsweise Schrauben, Haken, Ösen, Bänder, Schlaufen, Klettverschlüsse oder doppelseitige Klebebänder in Frage.

Für eine zuverlässige Einspeisung von in den Lichtsignalen enthaltenen Informationen in die lichtleitende Schicht ist es günstig, wenn die lichtleitende Schicht mit einer Lichteinspeisevorrichtung zur Einspeisung von Lichtsignalen verbunden ist.

Um mit kostengünstigen Komponenten eine zuverlässige Signalübertragung zu den Ansteuereinheiten zu gewährleisten, ist es bevorzugt, dass die Lichteinspeisevorrichtung zur Einspeisung von Lichtsignalen, die lichtleitende Schicht für eine Lichtübertragung und die Ansteuereinheiten für einen Lichtempfang jeweils im Infrarotbereich ausgebildet sind. Auf diese Weise lassen sich Störungen der Signalübertragung durch Umgebungslicht im sichtbaren Wellenlängenbereich verhindern. Zudem kann in diesem Frequenzbereich die Lichtübertragung in der lichtleitenden Schicht mit sehr geringen Dämpfungsverlusten erfolgen. Die Ansteuereinheiten, gegebenenfalls die lichterfassenden Anschlüsse, weisen Infrarotstrahlung detektierende Bauelemente auf.

Gemäß einer bevorzugten Ausführungsform kann vorgesehen sein, dass die Lichteinspeisevorrichtung ein sich über die erste und/oder zweite elektrisch leitfähige Schicht hinaus erstreckender Teil der lichtleitenden Schicht oder ein mit der lichtleitenden Schicht verbundener Stecker oder eine mit der lichtleitenden Schicht verbundene Lichtquelle ist. Ein sich im Wesentlichen über den Rand des Trägerkörpers hinaus erstreckender Teil der lichtleitenden Schicht oder ein an der lichtleitenden Schicht angeordneter Stecker bilden eine einfache Verbindungsmöglichkeit, beispielsweise eine Steck- oder Klemmverbindung, mit einem lichtleitenden Anschlusskabel. Demgegenüber kann eine an der lichtleitenden Schicht angeordnete Lichtquelle direkt, ohne eine vorausgehende Umwandlung in Lichtsignale, über elektrische Anschlusskabel mit elektrischen Signalen angesteuert werden. Die Lichtquelle ist insbesondere für eine effiziente bzw. verlustarme Einspeisung der hierdurch erzeugten Lichtsignale in die lichtleitende Schicht ausgebildet. Beispielsweise kann die Lichtquelle zumindest zum Teil in die lichtleitende Schicht eingebettet sein, wobei die elektrischen Anschlüsse der Lichtquelle aus der lichtleitenden Schicht herausragen.

Besonders günstig ist es, wenn die Lichteinspeisevorrichtung mit einem Steuergerät verbunden ist, welches einen Speicher für Adressen und Steuerinformationen für die einzeln ansteuerbaren Leuchtkörper aufweist, wobei das Steuergerät zur Einspeisung von die Adressen und die Steuerinformationen enthaltenden Steuersignalen in die Lichteinspeisevorrichtung ausgebildet ist. Das Steuergerät enthält somit die für die individuelle Ansteuerung der Leuchtkörper bzw. der Ansteuereinheiten nötigen Informationen und stellt diese Informationen der Lichteinspeisevorrichtung über eine Datenverbindung zur Verfügung. Das Steuergerät kann somit an einem vom Trägerkörper entfernten Ort positioniert sein. Für eine drahtgebundene Verbindung des Steuergeräts mit dem Trägerkörper bzw. der Lichteinspeisevorrichtung, beispielsweise über das Internet, können elektrisch leitende Kabel vorgesehen sein, wobei dann die Lichteinspeisevorrichtung die Umwandlung elektrischer in optische Signale vornimmt, oder die Verbindung wird über lichtleitende Kabel, insbesondere Glasfaserkabel hergestellt, wenn das Steuergerät die optischen Signale für die Einspeisung in die lichtleitende Schicht bereitstellt. Die Verbindung zwischen dem Steuergerät und der Lichteinspeisevorrichtung kann auch drahtlos über einen vordefinierten Funkstandard erfolgen. In diesem Fall weist das Steuergerät ein Funkmodul zum Senden, gegebenenfalls auch zum Empfangen von Funksignalen und die Lichteinspeisevorrichtung ein damit zusammenwirkendes Funkmodul zum Empfangen, gegebenenfalls auch zum Senden von Funksignalen auf. Der Speicher des Steuergeräts enthält die Adressen der anzusteuernden Leuchtkörper und die Steuerinformationen für die mit den Adressen ausgewählten Leuchtkörper. Die Steuerinformationen können einen Einschaltbefehl, einen Ausschaltbefehl sowie Anweisungen zur Leuchtfarbe und/oder zur einzustellenden Helligkeit des jeweiligen Leuchtkörpers beinhalten. Um mit den Leuchtkörpern ein definiertes Muster zu erzeugen, weist das Steuergerät im Speicher zudem Ablaufinformationen auf, welche den Zeitablauf der Einspeisung der individuellen Adress- und Steuerinformationen in die Lichteinspeisevorrichtung festlegen. Sobald eine Ansteuereinheit die eigene Adresse erkennt, steuert diese Ansteuereinheit den damit verbundenen Leuchtkörper entsprechend den mit dieser Adresse verknüpften Steuerinformationen. Das Steuergerät verfügt zweckmäßiger Weise auch über eine Verarbeitungseinheit, beispielsweise einen Mikroprozessor, und über Eingabemittel, um die Adressinformationen, die Steuerinformationen und die Ablaufinformationen in das Steuergerät eingeben bzw. einspeichern zu können.

Vorteilhafter Weise sind die Adressen und/oder die Steuerinformationen in der lichtleitenden Schicht durch Lichtsignale in unterschiedlichen Frequenzbereichen oder durch eine digitale Bitfolge gebildet. Die Übertragung der Adress- und Steuerinformationen erfolgt demnach entweder analog, indem jede Adresse einem schmalen Frequenzband entspricht und jede Ansteuereinheit ein Frequenzfilter für das der eigenen Adresse entsprechende Frequenzband aufweist, oder die Übertragung erfolgt digital, gemäß einem vordefinierten Übertragungsprotokoll. Vorzugsweise folgt die Steuerinformation für einen oder mehrere Leuchtkörper auf die damit verknüpfte Adressinformation, noch bevor die Adressinformation für einen oder mehrere andere Leuchtkörper übertragen wird. Es ist jedoch auch eine Kombination von analoger und digitaler Übertragung denkbar, indem beispielsweise nur die Adressen in Form von Lichtsignalen in unterschiedlichen Frequenzbändern übertragen werden und nur die Steuerinformationen in Form einer digitalen Bitfolge übertragen werden.

Zur Festlegung der Adressen der Leuchtkörper ist es günstig, wenn jede Ansteuereinheit eine vordefinierte Adresse für den damit verbundenen Leuchtkörper aufweist oder zur selbstständigen Festlegung einer Adresse des damit verbundenen Leuchtkörpers ausgebildet ist. Um einen eindeutigen Zusammenhang zwischen der Adresse und der Position der Leuchtkörper herzustellen, können die Ansteuereinheiten somit jeweils mit einer definierten, eindeutigen Adresse vorprogrammiert und an dem Steuergerät bekannten Positionen am Trägerkörper angeordnet sein. Alternativ können die Ansteuereinheiten identisch, ohne individuelle Vorprogrammierung ausgebildet sein und die Adressen der Leuchtkörper im am Trägerkörper montierten Zustand selbstständig festlegen.

Die selbstständige Ermittlung bzw. Festlegung der Adresse kann erfolgen, indem zwei entlang der lichtleitenden Schicht gedämpfte Referenz-Lichtsignale von unterschiedlichen Positionen in die lichtleitende Schicht eingespeist und deren positionsabhängige Lichtstärke von den Ansteuereinheiten gemessen werden. Hierfür ist zweckmäßiger Weise vorgesehen, dass die lichtleitende Schicht lichtdämpfend ausgebildet ist, eine in einem Winkel, vorzugsweise einem rechten Winkel, zur Lichteinspeisevorrichtung angeordnete zweite Lichteinspeisevorrichtung mit der lichtleitenden Schicht und dem Steuergerät verbunden ist und jede Ansteuereinheit zum Messen der gedämpften Lichtstärke von mittels dem Steuergerät und der beiden Lichteinspeisevorrichtungen eingespeisten Referenz-Lichtsignalen definierter Stärken ausgebildet ist, welche gemessenen Lichtstärken die Adressen repräsentieren.

Zweckmäßiger Weise sind die zur selbstständigen Festlegung einer Adresse ausgebildeten Ansteuereinheiten für eine Übertragung der festgelegten Adressen an das Steuergerät mittels in die lichtleitende Schicht eingespeisten Lichtsignalen ausgebildet und das Steuergerät ist für den Empfang der Lichtsignale ausgebildet. Hierfür weisen die Ansteuereinheiten Sendeeinrichtungen für die Lichtsignale und das Steuergerät Empfangseinrichtungen für diese Lichtsignale auf. Auf diese Weise werden die von den Ansteuereinheiten festgelegten Adressen dem Steuergerät mitgeteilt. Um Kollisionen der die Adressen repräsentierenden Lichtsignale möglichst zu vermeiden, können diese entweder in zufälliger Reihenfolge oder zu einem von der festgelegten Adresse abhängigen Zeitpunkt gesendet werden. Das Steuergerät ist dann günstiger Weise ausgebildet, die den empfangenen Adressen zugeordneten Positionen der Leuchtkörper am Trägerkörper entsprechend den Adresswerten zu schätzen, da abnehmende Adresswerte auf eine zunehmende Distanz zu den Lichteinspeisevorrichtungen zurückgehen.

Das Steuergerät kann jedoch auch zur selbstständigen Ermittlung der von den Ansteuereinheiten festgelegten Adressen der Leuchtkörper ausgebildet sein, indem das Steuergerät Werte der von den Lichteinspeisevorrichtungen in die lichtleitende Schicht eingespeisten Referenz-Lichtstärken, zumindest einen Wert der Dämpfung der lichtleitenden Schicht und Informationen über die Verteilung der Leuchtkörper auf dem Trägerkörper aufweist. Auf diese Weise kann das Steuergerät die Werte der von den Ansteuereinheiten gemessenen Lichtstärken zumindest näherungsweise berechnen. Hierfür ist es günstig, wenn die lichtleitende Schicht entlang ihrer gesamten Erstreckung eine definierte, vorzugsweise in allen Richtungen gleiche Dämpfung aufweist.

Die Vorrichtung zur Bilddarstellung kann somit mechanisch belastbar, witterungsbeständig, größen- und formgestaltbar, flexibel und dünn, beispielsweise in Form einer Folie, und einfach montierbar, für die Darstellung bewegter oder unbewegter, ein- oder mehrfarbiger Bildinhalte ausgebildet sein. Die Vorrichtung kann insbesondere als Bildschirm, Plakatwand, zur Beleuchtung von Räumen oder als Designelement Anwendung finden.

Die Erfindung wird im Folgenden anhand von bevorzugten, nicht einschränkenden Ausführungsbeispielen unter Bezugnahme auf die Zeichnung noch weiter erläutert. Es zeigen:
Fig. 1 eine schematische Schnittdarstellung einer Ausführungsform eines Trägerkörpers mit einem Steuergerät;
Fig. 2 einen Teil eines Trägerkörpers gemäß einer anderen Ausführungsform; und
Fig. 3 eine schematische Ansicht der erfindungsgemäßen Vorrichtung von oben.

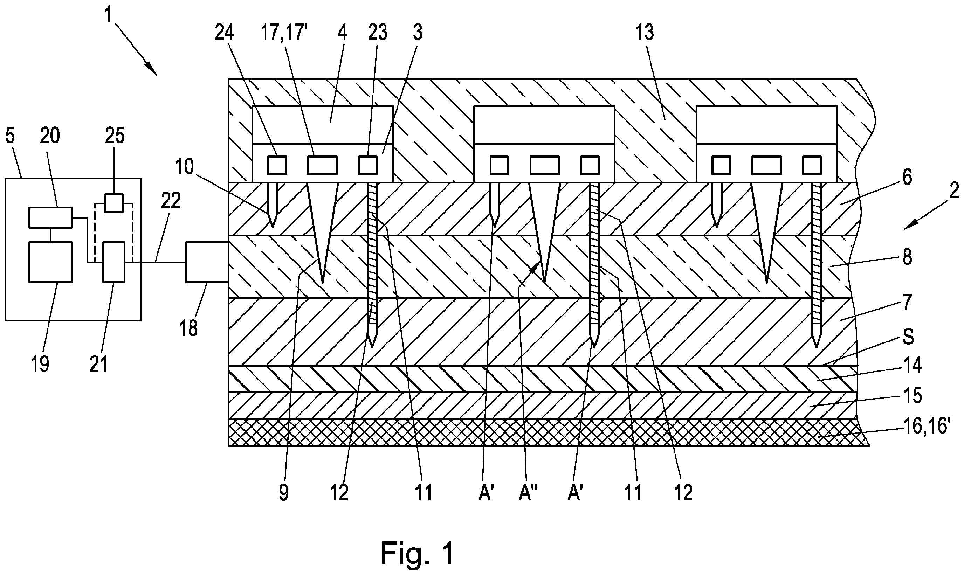

Fig. 1 zeigt eine Vorrichtung 1 zur Bilddarstellung mit einem Trägerkörper 2, auf welchem mit jeweils einer Ansteuereinheit 3 verbundene, einzeln ansteuerbare Leuchtkörper 4 angeordnet sind, und mit einem Steuergerät 5. Der Trägerkörper 2 weist eine erste elektrisch leitfähige Schicht 6 auf, welche den Leuchtkörpern 4 zugewandt ist, eine zweite elektrisch leitfähige Schicht 7, welche von den Leuchtkörpern 4 abgewandt ist, und eine zwischen der ersten und zweiten elektrisch leitfähigen Schicht 6, 7 angeordnete elektrisch isolierende lichtleitende Schicht 8 zur Leitung von Lichtsignalen. Zur Erfassung der Lichtsignale, gemäß welchen die Leuchtkörper 4 von den Ansteuereinheiten 3 elektrisch angesteuert werden, sind die Ansteuereinheiten 3 über lichterfassende Anschlüsse 9 mit der lichtleitenden Schicht 8 verbunden. Zudem sind erste elektrische Anschlüsse 10 zur Verbindung der Ansteuereinheiten 3 mit der ersten elektrisch leitfähigen Schicht 6 und zweite elektrische Anschlüsse 11 zur Verbindung der Ansteuereinheiten 3 mit der zweiten elektrisch leitfähigen Schicht 7 vorgesehen, um die Ansteuereinheiten 3 und die Leuchtkörper 4 mit Strom zu versorgen. Um ein Einstechen in den Trägerkörper 2 zu erleichtern, weisen der erste elektrische Anschluss 10, der zweite elektrische Anschluss 11 und der lichterfassende Anschluss 9 einen in Richtung weg von den Leuchtkörpern 4 verjüngend ausgebildeten Abschnitt A', A" auf, wobei die elektrischen Anschlüsse 10, 11 nadelförmig mit einem Abschnitt A' und die lichterfassenden Anschlüsse 9 kegelförmig mit einem Abschnitt A" ausgebildet sind. Selbstverständlich ist aber auch jede andere für ein Einstechen geeignete Form der Anschlüsse 9, 10, 11 der Ansteuereinheiten 3 denkbar. Wie Fig. 1 zu entnehmen ist, weist der zweite elektrische Anschluss 11 im am Trägerkörper 2 montierten Zustand eine sich zumindest entlang der Dicke der ersten elektrisch leitfähigen Schicht 6 erstreckende Isolationsschicht 12 auf, um einen elektrischen Kurzschluss der beiden elektrisch leitfähigen Schichten 6, 7 zu vermeiden. Der lichterfassende Anschluss 9 erstreckt sich vorzugsweise möglichst tief in die lichtleitende Schicht 8, um die Lichtsignale zuverlässig erfassen zu können. Obgleich der erste elektrische Anschluss 10 in die erste elektrisch leitfähige Schicht 6 eingestochen dargestellt ist, könnte er auch als auf der Schicht 6 aufliegende Kontaktfläche ausgebildet sein. Im Unterschied zu der in Fig. 1 dargestellten Ausführungsform können die elektrischen Anschlüsse 10, 11 und der lichterfassende Anschluss 9 auch fest im Trägerkörper 2 vorgesehen sein und sich zumindest bis an die Oberseite der ersten elektrisch leitfähigen Schicht 6 erstrecken, um die Ansteuereinheiten 3 darauf aufzusetzen. Auf diese Weise können die beiden elektrisch leitfähigen Schichten 6, 7 und die lichtleitende Schicht 8 besonders dünn ausgebildet sein, da dann kein Einstechvorgang in den Trägerkörper 2 erforderlich ist.

Die Leuchtkörper 4, vorzugsweise LEDs oder Piezokristalle, sind in Fig. 1 im Querschnitt rechteckig dargestellt, können jedoch auch hierzu unterschiedlich, beispielsweise halbkugelförmig geformt sein. Um die Leuchtkörper 4 vor Umwelteinflüssen oder Beschädigungen zu schützen, sind die Leuchtkörper 4 im Beispiel der Fig. 1 vollständig in eine lichtdurchlässige Deckschicht 13 eingebettet, welche auf der ersten elektrisch leitfähigen Schicht 6 angeordnet ist. Zudem weist der Trägerkörper 2 auf der von den Leuchtkörpern 4 abgewandten Seite S der zweiten elektrisch leitfähigen Schicht 7 eine elektrisch isolierende Schicht 14 auf. Um dem Trägerkörper 2 zusätzliche mechanische Stabilität zu verleihen, kann optional eine Trageschicht 15 auf der elektrisch isolierenden Schicht 14 angeordnet sein. Eine auf der elektrisch isolierenden Schicht 14 oder, wie in Fig. 1 dargestellt ist, auf der Trageschicht 15 angeordnete Selbstklebeschicht 16' oder ein sonstiges Befestigungsmittel 16 erleichtert die Befestigung des Trägerkörpers 2 auf einem geeigneten Untergrund. Die Schichten des Trägerkörpers 2, d.h. die erste elektrisch leitfähige Schicht 6, die zweite elektrisch leitfähige Schicht 7, die lichtleitende Schicht 8, sowie gegebenenfalls die Deckschicht 13, die elektrisch isolierende Schicht 14, die Trageschicht 15 und die Selbstklebeschicht 16' sind bevorzugt biegsam ausgebildet, um den Trägerkörper 2 möglichst vollflächig auf unebenen Flächen befestigen, insbesondere ankleben, zu können. Die Schichten des Trägerkörpers 2 sollen zudem möglichst dünn sein, beispielsweise in Form einer Folie, und vom Benutzer der Vorrichtung mit herkömmlichen Werkzeugen, wie Scheren oder Messern, zu durchtrennen sein, um die Form des Trägerkörpers 2 bedarfsweise zu ändern. Die Fläche des Trägerkörpers 2 kann wenige cm² bis mehrere m², beispielsweise zwischen 5cm² und 10m², bevorzugt im Falle der Anwendung als Bildschirm zwischen 100cm² und 2m², betragen. Die gesamte Dicke des Trägerkörpers 2, inklusive der Deckschicht 13, der elektrisch isolierenden Schicht 14, der Trageschicht 15 und der Selbstklebeschicht 16', liegt günstiger Weise im Bereich weniger mm und beträgt vorzugsweise zwischen 3mm und 10mm. Der Trägerkörper 2 lässt sich noch besser vor Beschädigung schützen, wenn die lichtleitende Schicht 8 einen sich selbst regenerierenden Kunststoff aufweist.

Zur Erfassung der Lichtsignale in der lichtleitenden Schicht 8 weist die Ansteuereinheit 3 einen Empfänger 17 für Lichtsignale, vorzugsweise für Infrarotsignale, auf. Der Empfänger 17 ist im Beispiel der Fig. 1 in einem Abschnitt außerhalb des lichterfassenden Anschlusses 9 der Ansteuereinheit 3 angeordnet, wobei der lichterfassende Anschluss 9 ausgebildet ist, die Lichtsignale an den Empfänger 17 weiterzuleiten. Die Ansteuereinheit 3 wandelt die empfangenen Lichtsignale in elektrische Signale um, mit welchen die Lichtabgabe der Leuchtkörper 4 gesteuert wird.

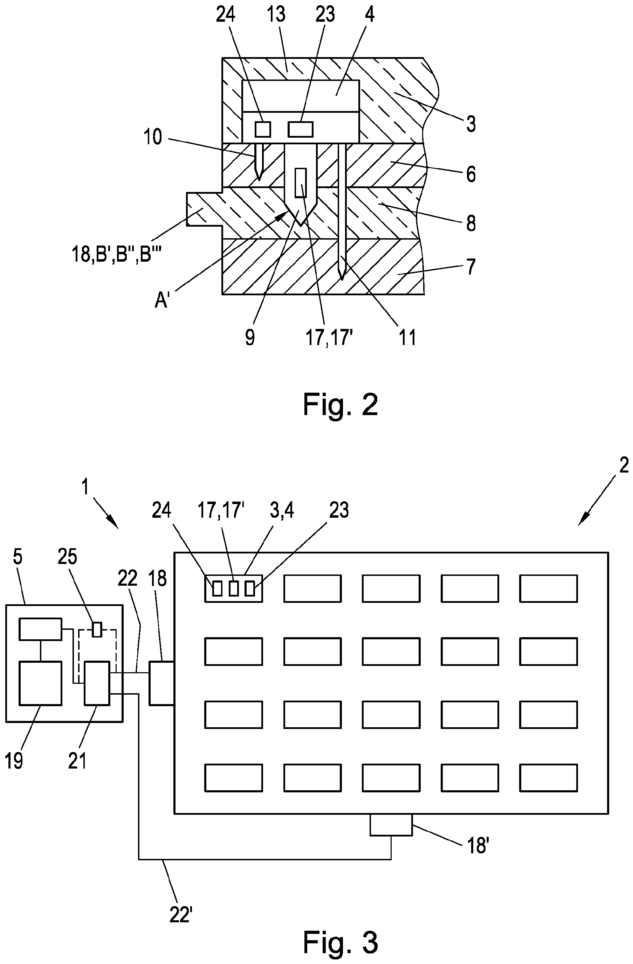

Um Lichtsignale in die lichtleitende Schicht 8 einspeisen zu können, ist die lichtleitende Schicht 8 mit einer Lichteinspeisevorrichtung 18 verbunden. Wie aus Fig. 2 ersichtlich ist, kann die Lichteinspeisevorrichtung 18 ein sich über die erste und/oder zweite elektrisch leitfähige Schicht 6, 7 hinaus erstreckender Teil B' der lichtleitenden Schicht 8 oder ein mit der lichtleitenden Schicht 8 verbundener Stecker B" oder eine mit der lichtleitenden Schicht 8 verbundene Lichtquelle B"' sein. Fig. 2 zeigt zudem einen zur Darstellung in Fig. 1 unterschiedlich ausgebildeten nadelförmigen, lichterfassenden Anschluss 9 mit einem verjüngend ausgebildeten Abschnitt A'. Der lichterfassende Anschluss 9 weist zudem den Empfänger 17 für Lichtsignale auf.

Wie weiters in Fig. 1 zu erkennen ist, ist die Lichteinspeisevorrichtung 18 mit dem Steuergerät 5 verbunden, welches einen Speicher 19 für Adressen und Steuerinformationen für die einzeln ansteuerbaren Leuchtkörper 4 aufweist. Zudem weist das Steuergerät eine Verarbeitungseinheit 20, insbesondere einen Mikroprozessor, zur Bereitstellung der die Adressen und die Steuerinformationen enthaltenden Steuersignale und eine Einheit 21 zur Erzeugung der in die Lichteinspeisevorrichtung 18 einzuspeisenden elektrischen oder optischen Steuersignale auf. Das Steuergerät 5, insbesondere die Einheit 21, ist über ein Kabel 22 oder über ein nicht dargestelltes Funkmodul mit der Lichteinspeisevorrichtung 18 verbunden.

Fig. 3 zeigt einen rechteckigen, mit dem Steuergerät 5 verbundenen Trägerkörper 2, mit in Form einer Matrix angeordneten Leuchtkörpern 4, in einer Ansicht von oben. Für den Fall, dass die Ansteuereinheiten 3 nicht mit definierten Adressen vorprogrammiert sind, können die Ansteuereinheiten 3 für eine selbstständige Festlegung ihrer Adressen ausgebildet sein. Hierfür ist das Steuergerät 5 über ein Kabel 22' mit einer zweiten Lichteinspeisevorrichtung 18' verbunden, wobei die Lichteinspeisevorrichtungen 18, 18' vorzugsweise an unterschiedlichen, günstiger Weise im Wesentlichen einen rechten Winkel einschließenden Seitenflächen des Trägerkörpers 2 angeordnet sind. Für die Festlegung der Adressen messen die Ansteuereinheiten 3 die ortsabhängigen Stärken von Referenz-Lichtsignalen, welche von den Lichteinspeisevorrichtungen 18, 18' mit definierter Stärke in die lichtleitende Schicht 8 eingespeist werden. Hierfür weisen die Ansteuereinheiten 3 eine Messeinrichtung 23 auf. Die lichtleitende Schicht 8 ist für diesen Fall lichtdämpfend ausgebildet. Die vorprogrammierten oder die selbstständig festgelegten Adressen der Leuchtkörper 4 werden in einem Speicher 24 der Ansteuereinheiten 3 abgelegt. Um die selbstständig festgelegten Adressen mit Lichtsignalen an das Steuergerät 5 zu übertragen, weisen die Ansteuereinheiten 3 Sendeeinrichtungen 17' für die Lichtsignale auf und das Steuergerät 5 enthält eine Empfangseinrichtung 25 (s. Fig. 1) für diese Lichtsignale.

## Patentansprüche

1. Vorrichtung (1) zur Bilddarstellung mit einem Trägerkörper (2), auf welchem mit jeweils einer Ansteuereinheit (3) verbundene, einzeln ansteuerbare Leuchtkörper (4) angeordnet sind, **dadurch gekennzeichnet, dass** der Trägerkörper (2) eine den Leuchtkörpern (4) zugewandte erste elektrisch leitfähige Schicht (6), eine von den Leuchtkörpern (4) abgewandte zweite elektrisch leitfähige Schicht (7) und eine zwischen der ersten (6) und zweiten elektrisch leitfähigen Schicht (7) angeordnete lichtleitende Schicht (8) zur Leitung von Lichtsignalen aufweist, wobei die Ansteuereinheiten (3) über lichterfassende Anschlüsse (9) mit der lichtleitenden Schicht (8) verbunden sind, wobei erste elektrische Anschlüsse (10) zur Verbindung der Ansteuereinheiten (3) mit der ersten elektrisch leitfähigen Schicht (6) und zweite elektrische Anschlüsse (11) zur Verbindung der Ansteuereinheiten (3) mit der zweiten elektrisch leitfähigen Schicht (7) vorgesehen sind, wobei die Ansteuereinheiten (3) zur Ansteuerung der Leuchtkörper (4) in Abhängigkeit von in die lichtleitende Schicht (8) eingespeisten Lichtsignalen ausgebildet sind.

2. Vorrichtung (1) nach Anspruch 1, **dadurch gekennzeichnet, dass** die ersten und/oder zweiten elektrischen Anschlüsse (10, 11) und/oder die lichterfassenden Anschlüsse (9) einen in Richtung weg von den Leuchtkörpern (4) verjüngend ausgebildeten Abschnitt (A', A'') aufweisen.

3. Vorrichtung (1) nach Anspruch 1 oder 2, **dadurch gekennzeichnet, dass** die Leuchtkörper (4) Licht emittierende Dioden (LEDs), vorzugsweise für die Emission unterschiedlicher Lichtfarben steuerbare RGB LEDs oder elektrisch verformbare Materialien, insbesondere Piezokristalle, sind.

4. Vorrichtung (1) nach einem der Ansprüche 1 bis 3, **dadurch gekennzeichnet, dass** der Trägerkörper (2) biegsam ist.

5. Vorrichtung (1) nach einem der Ansprüche 1 bis 4, **dadurch gekennzeichnet, dass** die erste elektrisch leitfähige Schicht (6) mit einer die Leuchtkörper (4) zumindest teilweise einbettenden Deckschicht (13) verbunden ist.

6. Vorrichtung (1) nach einem der Ansprüche 1 bis 5, **dadurch gekennzeichnet, dass** die zweite elektrisch leitfähige Schicht (7) auf der von den Leuchtkörpern (4) abgewandten Seite (S) mit einer elektrisch isolierenden Schicht (14) verbunden ist.

7. Vorrichtung (1) nach einem der Ansprüche 1 bis 6, **dadurch gekennzeichnet, dass** der Trägerkörper (2) auf der von den Leuchtkörpern (4) abgewandten Seite Befestigungsmittel (16), insbesondere eine Selbstklebeschicht (16'), aufweist.

8. Vorrichtung (1) nach einem der Ansprüche 1 bis 7, **dadurch gekennzeichnet, dass** die lichtleitende Schicht (8) mit einer Lichteinspeisevorrichtung (18) zur Einspeisung von Lichtsignalen verbunden ist.

9. Vorrichtung (1) nach Anspruch 8, **dadurch gekennzeichnet, dass** die Lichteinspeisevorrichtung (18) zur Einspeisung von Lichtsignalen, die lichtleitende Schicht (8) für eine Lichtübertragung und die Ansteuereinheiten (3) für einen Lichtempfang jeweils im Infrarotbereich ausgebildet sind.

10. Vorrichtung (1) nach Anspruch 8 oder 9, **dadurch gekennzeichnet, dass** die Lichteinspeisevorrichtung (18) ein sich über die erste und/oder zweite elektrisch leitfähige Schicht (6, 7) hinaus erstreckender Teil (B') der lichtleitenden Schicht (8) oder ein mit der lichtleitenden Schicht (8) verbundener Stecker (B'') oder eine mit der lichtleitenden Schicht (8) verbundene Lichtquelle (B''') ist.

11. Vorrichtung (1) nach einem der Ansprüche 8 bis 10, **dadurch gekennzeichnet, dass** die Lichteinspeisevorrichtung (18) mit einem Steuergerät (5) verbunden ist, welches einen Speicher (19) für Adressen und Steuerinformationen für die einzeln ansteuerbaren Leuchtkörper (4) aufweist, wobei das Steuergerät (5) zur Einspeisung von die Adressen und die Steuerinformationen enthaltenden Steuersignalen in die Lichteinspeisevorrichtung (18) ausgebildet ist.

12. Vorrichtung (1) nach Anspruch 11, **dadurch gekennzeichnet, dass** die Adressen und/oder die Steuerinformationen in der lichtleitenden Schicht (8) durch Lichtsignale in unterschiedlichen Frequenzbereichen oder durch eine digitale Bitfolge gebildet sind.

## Claims

1. Device (1) for image representation, comprising a carrier body (2) on which are arranged individually driveable luminous bodies (4) connected respectively to a drive unit (3), **characterized in that** the carrier body (2) comprises a first electrically conductive layer (6) facing the luminous bodies (4), a second electrically conductive layer (7) facing away from the luminous bodies (4) and a light-guiding layer (8) arranged between the first (6) and the second electrically conductive layer (7) for guiding light signals, wherein the drive units (3) are connected to the light-guiding layer (8) via light-capturing connections (9), wherein first electrical connections (10) for connecting the drive units (3) to the first electrically conductive layer (6) and second electrical connections (11) for connecting the drive units (3) to the second electrically conductive layer (7) are provided, wherein the drive units (3) are designed for driving the luminous bodies (4) depending on light signals fed into the light-guiding layer (8).

2. Device (1) according to claim 1, **characterized in that** the first and/or second electrical connections (10, 11) and/or the light-capturing connections (9) comprise a section (A', A") tapering in the direction away from the luminous bodies (4).

3. Device (1) according to claim 1 or 2, **characterized in that** the luminous bodies (4) are light-emitting diodes (LEDs), preferably RGB LEDs driveable for emitting different light colours or electrically deformable materials, in particular piezoelectric crystals.

4. Device (1) according to one of claims 1 to 3, **characterized in that** the carrier body (2) is flexible.

5. Device (1) according to one of claims 1 to 4, **characterized in that** the first electrically conductive layer (6) is connected to a top layer (13) at least partially embedding the luminous bodies (4).

6. Device (1) according to one of claims 1 to 5, **characterized in that** the second electrically conductive layer (7) is connected to an electrically insulating layer (14) on the side (S) facing away from the luminous bodies (4).

7. Device (1) according to one of claims 1 to 6, **characterized in that** the carrier body (2) comprises fastening means (16), in particular a self-adhesive layer (16'), on the side facing away from the luminous bodies (4).

8. Device (1) according to one of claims 1 to 7, **characterized in that** the light-guiding layer (8) is connected to a light-feeding device (18) for feeding light signals.

9. Device (1) according to claim 8, **characterized in that** the light-feeding device (18) for feeding light signals, the light-guiding layer (8) for light transmission and the drive units (3) for light reception are each designed to work in the infrared range.

10. Device (1) according to claim 8 or 9, **characterized in that** the light-feeding device (18) is a part (B') of the light-guiding layer (8), the part (B') extending beyond the first and/or second electrically conductive layer (6, 7) or a plug (B") connected to the light-guiding layer (8) or a light source (B"') connected to the light-guiding layer (8).

11. Device (1) according to one of claims 8 to 10, **characterized in that** the light-feeding device (18) is connected to a control device (5) which comprises a memory (19) for addresses and control information for the individually driveable luminous bodies (4), the control device (5) being designed to feed control signals containing the addresses and the control information into the light-feeding device (18).

12. Device (1) according to claim 11, **characterized in that** the addresses and/or the control information in the light-guiding layer (8) are formed by light signals in different frequency ranges or by a digital bit sequence.

## Revendications

1. Dispositif (1) pour la représentation d'image avec un corps support (2), sur lequel des corps lumineux (4) pouvant être commandés individuellement, reliés à respectivement une unité de commande (3) sont agencés, **caractérisé en ce que** le corps support (2) présente une première couche électriquement conductrice (6) tournée vers les corps lumineux (4), une deuxième couche électriquement conductrice (7) opposée aux corps lumineux (4) et une couche conductrice de lumière (8) agencée entre les première (6) et deuxième (7) couches électriquement conductrices pour la conduction de signaux lumineux, dans lequel les unités de commande (3) sont reliées à la couche conductrice de lumière (8) par le biais de raccords capturant la lumière (9), dans lequel des premiers raccords électriques (10) sont prévus pour la liaison des unités de commande (3) à la première couche électriquement conductrice (6) et des deuxièmes raccords électriques (11) sont prévus pour la liaison des unités de commande (3) à la deuxième couche électriquement conductrice (7), dans lequel les unités de commande (3) sont réalisées pour la commande de corps lumineux (4) en fonction de signaux lumineux injectés dans la couche conductrice de lumière (8).

2. Dispositif (1) selon la revendication 1, **caractérisé en ce que** les premiers et/ou deuxièmes raccords électriques (10, 11) et/ou les raccords capturant la lumière (9) présentent une section (A', A") réalisée pour s'effiler dans la direction s'éloignant des corps lumineux (4).

3. Dispositif (1) selon la revendication 1 ou 2, **caractérisé en ce que** les corps lumineux (4) sont des diodes électroluminescentes (DEL), de préférence des DEL RVB pouvant être commandées pour l'émission de différentes couleurs lumineuses ou des matériaux électriquement déformables, en particulier des cristaux piézoélectriques.

4. Dispositif (1) selon l'une quelconque des revendications 1 à 3, **caractérisé en ce que** le corps support (2) est flexible.

5. Dispositif (1) selon l'une quelconque des revendications 1 à 4, **caractérisé en ce que** la première couche électriquement conductrice (6) est reliée à une couche de recouvrement (13) intégrant au moins en partie les corps lumineux (4).

6. Dispositif (1) selon l'une quelconque des revendications 1 à 5, **caractérisé en ce que** la deuxième couche électriquement conductrice (7) est reliée à une couche électriquement isolante (14) sur le côté (S) opposé aux corps lumineux (4).

7. Dispositif (1) selon l'une quelconque des revendications 1 à 6, **caractérisé en ce que** le corps support (2) présente sur le côté opposé aux corps lumineux (4) des moyens de fixation (16), en particulier une couche autocollante (16').

8. Dispositif (1) selon l'une quelconque des revendications 1 à 7, **caractérisé en ce que** la couche conductrice de lumière (8) est reliée à un dispositif d'injection de lumière (18) pour l'injection de signaux lumineux.

9. Dispositif (1) selon la revendication 8, **caractérisé en ce que** le dispositif d'injection de lumière (18) est réalisé pour l'injection de signaux de lumière, la couche conductrice de lumière (8) est réalisée pour une transmission de lumière et les unités de commande (3) sont réalisées pour une réception de lumière respectivement dans le domaine infrarouge.

10. Dispositif (1) selon la revendication 8 ou 9, **caractérisé en ce que** le dispositif d'injection de lumière (18) est une partie (B') de la couche conductrice de lumière (8) s'étendant au-delà de la première et/ou deuxième couche électriquement conductrice (6, 7) ou un connecteur (B") relié à la couche conductrice de lumière (8) ou une source de lumière (B'") reliée à la couche conductrice de lumière (8).

11. Dispositif (1) selon l'une quelconque des revendications 8 à 10, **caractérisé en ce que** le dispositif d'injection de lumière (18) est relié à un appareil de commande (5), lequel présente une mémoire (19) pour des adresses et des informations de commande pour les corps lumineux (4) pouvant être commandés individuellement, dans lequel l'appareil de commande (5) est réalisé pour l'injection de signaux de commande contenant les adresses et les informations de commande dans le dispositif d'injection de lumière (18).

12. Dispositif (1) selon la revendication 11, **caractérisé en ce que** les adresses et/ou les informations de commande sont formées dans la couche conductrice de lumière (8) par des signaux lumineux dans différences plages de fréquence ou par une chaîne de bits numérique.
